# EUROPEAN PATENT APPLICATION

(11) **EP 1 455 397 A2**
(43) Date of publication of application: **08.09.2004**
(21) Application number: 03029916.8
(22) Date of filing: 29.12.2003
(51) Int. Cl.: H01L 29/78, H01L 29/423, H01L 29/08, H01L 21/336

(54) **Vertical MOS device and method of making the same**

(30) Priority: 30.12.2002 EP 02425803
(71) Applicant: STMicroelectronics S.r.l., 20041 Agrate Brianza (Milano) (IT)
(72) Inventor: Magri', Angelo, 95032 Belpasso (Catania) (IT); Frisina, Feruccio, 95030 Sant'Agata LiBattiati (Catania) (IT); Ferla, Giuseppe, 95126 Catania (IT); Camalleri, Marco, 20041 Agrate Brianza (MI) (IT)
(74) Representative: Ferrari, Barbara

(57) **Abstract**

The invention relates to a vertical-conduction and planar-structure MOS device having a double thickness of gate oxide comprising
- a first portion (5a) of gate oxide having a lower thickness in a channel area close to the active areas (4), and a second portion (5b) of thicker gate oxide in a central area (11) on a JFET area and
- an enrichment region (9) in the JFET area under the second . portion (5b) of thicker gate oxide (11).

The invention also relates to a method for realising on a semiconductor substrate (2) MOS transistor electronic devices (1) with improved static and dynamic performances and high scaling down density, these transistors having traditional active areas (4) defined in the substrate (2) at the periphery of a channel region whereon a gate region is realised. The method provides at least the following steps:
- realising the MOS transistor starting from a planar structure with a double thickness of gate oxide comprising a thin layer in the channel area close to the active areas (4) and a thicker layer in the central area (11) on the channel; and
- realising an enrichment region (9) in the JFET area below the thicker layer.

## Description

### Field of application

The present invention relates, in its more general aspect, to vertical-conduction MOS power devices and to a method for realising them on an industrial scale with high integration density.

More specifically, the invention relates to a vertical-conduction and planar-structure MOS device with a double thickness of gate oxide.

The invention also relates to a process for realising vertical-conduction MOS power devices starting from corresponding planar MOS structures.

Even more specifically, the present invention relates to a method for reducing the capacity of MOS devices of the type concerned, operating simultaneously and in a self-aligned way on corresponding planar MOS structures.

### Prior art

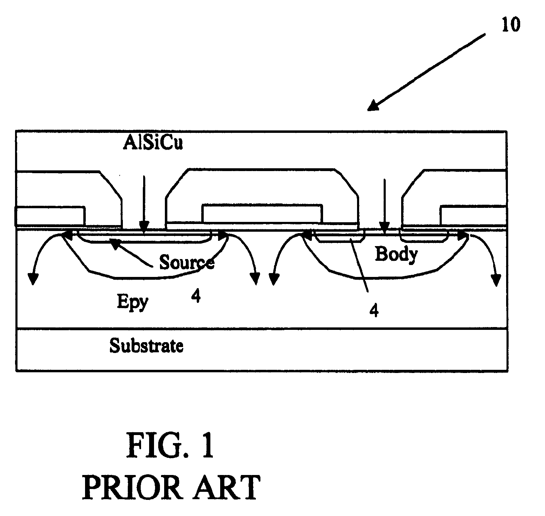

It is known that in a VDMOS device (figure 1) the resistive component due to the JFET area which is created between a body well and the other limits the increase of the packing density and thus the improvement of the device static and dynamic performances.

In fact the JFET resistance depends not only on the epitaxial layer resistivity but also on the distance between two adjacent body wells. The capacities associated to the gate oxide and thus the charge storage capacity of the gate region depend, in an opposite sense , on this distance.

On the other hand it is known that improving the output resistance by increasing the distance between the body wells means penalising the dynamic features of the device concerned.

This problem occurred up to now mainly in high voltage MOS devices (~500V) because of the high epitaxial layer resistivity (~20Ω*cm), while in low voltage devices (30-60V) the problem is considered almost negligible because of the low epitaxial layer resistivity (< 1 Ω*cm).

It is also known that, as far as PMOS devices are concerned, particularly low voltage PMOS, the higher and higher integration density (scaling down) and the realisation of submicrometric channel lengths, although obtained with different known technologies, led to a considerable reduction of the output resistance components due to the channel and to a greater focus on the component due to the JFET and to the need to reduce capacities.

By way of example of this trend, the following table 1 shows a comparison between the relative weight of the output resistance components of a 30-volt P-channel device.

| **Output resistance components for a 30-volt P-channel PMOS device** | **Relative weight** |
|---|---|
| Die-package connection | 25% |
| Substrate contribution | 12% |
| Epi layer contribution | 12% |
| Contribution of the JFET between body wells | 33% |
| Component due to the channel | 18% |
| **Ron** | 100% |

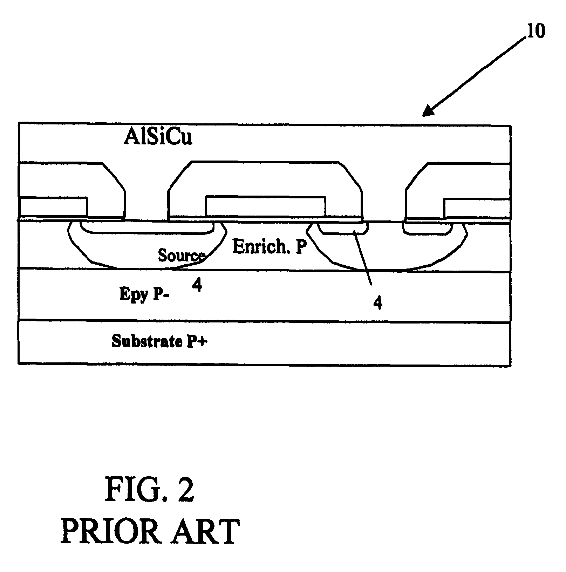

In order to preserve the dynamic features of a PMOS, and improve in parallel the output resistance thereof, methods based on the reduction of the distance between body wells have been implemented. These prior art methods essentially provide either the surface resistivity modification (figure 2) or the technology change:
a) surface enrichment between body wells in order to locally reduce resistivity (patent I.R. U.S. no. 4.376.286 and 4.974.059);
b) use of a low-resistivity surface epitaxial layer;
c) use of a trench technology.

The methods a) and b) applied to low voltage PMOS devices involve known technical drawbacks linked to the influence of the enriched layer on the channel.

In fact, as it is known, in a low voltage PMOS structure:
- the drain is characterised by an epitaxial layer whose concentration ranges between 1 and 5*10¹⁶ at/cm³.
- gate oxides, because of the low threshold voltage (driving with Vg<4.5V) and of the low capacities required by the applications, have a thickness not lower than 200 Å and peak concentrations in the channel do not exceed 10¹⁷ at/cm³.

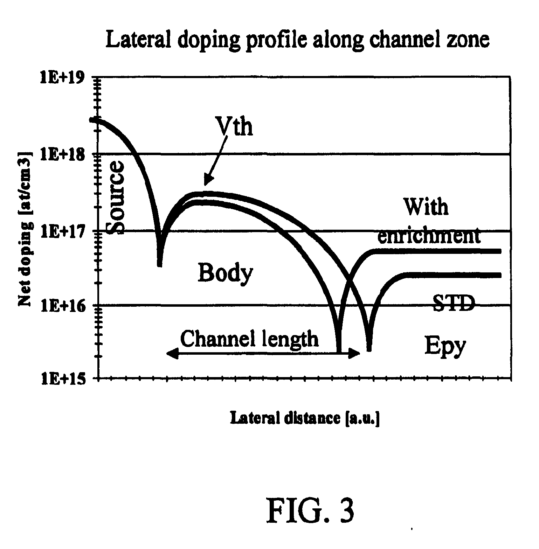

This means that the highest concentration in the channel is higher by almost an order of magnitude than the epitaxial layer concentration (figure 3). Consequently, as soon as attempts are made to enrich uniformly the whole surface, channel features (threshold voltage and channel length) are deeply changed jeopardising also the PMOS device functionality, this phenomenon being known in this field as premature punch through.

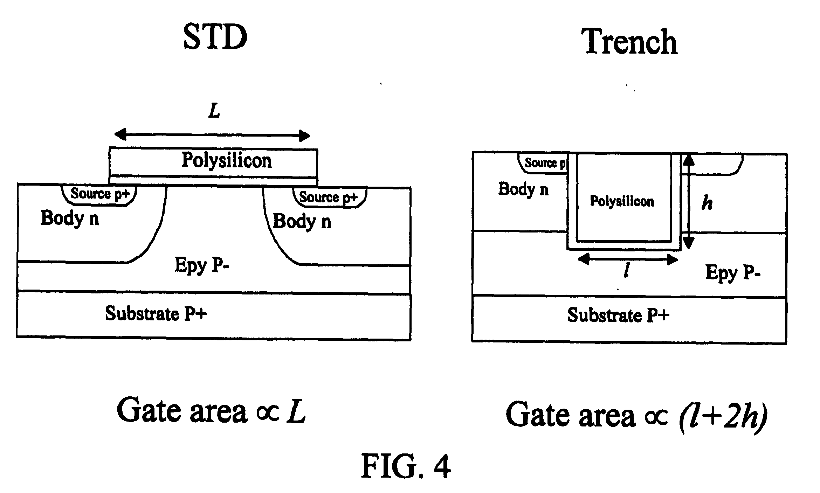

With the third mentioned method, point (c), the JFET component can be eliminated, but the capacity problem is not solved since in most cases the area whereon the gate oxide rests is increased, as shown by the comparison between the two gate structures represented in figure 4

In the case of a planar structure VDMOS the gate area is proportional to the distance L (1.5-4 µm) while in the case of a trench technology device it is proportional to the sum of the double depth and of the trench width (2h+1~ 2.5-4 µm).

The technical problem underlying the present invention is to provide a method for realising vertical-conduction MOS power devices having improved static and dynamic performances with respect to prior art devices, as well as capable of reducing the capacities of these devices for the same static performances.

### Summary of the invention

The solution idea underlying the present invention is to use a double thickness of gate oxide, a thin layer in the channel region and a thicker layer on inactive areas. In the meantime, it provides an enrichment of the JFET region in order to reduce the distance between the body regions and to increase the integration area reducing the extension of the gate oxide surface.

Based on this solution idea the technical problem is solved by a method for realising vertical MOS devices of the type concerned and characterised in that it comprises the steps of:
- realising on a planar MOS structure a double thickness for the gate oxide comprising a thin layer in the channel region of said structure, and a thicker layer in the inactive areas thereof and
- enriching, simultaneously and in a self-aligned way, the JFET area in order to reduce the distance between two adjacent body wells, reduce the gate oxide surface, obtaining an increased packing density.

The features and advantages of the method according to the present invention will be apparent from the following description of an embodiment thereof given by way of non-limiting example with reference to the attached drawings.

### Brief description of the drawings

- Figure 1 is a vertical-section and enlarged-scale schematic view of a prior art traditional PMOS electronic device underlining the current flow direction during the operation condition;
- Figure 2 is a vertical-section and enlarged-scale schematic view of a prior art surface-enriched PMOS electronic device;
- Figure 3 shows on a doping concentration vs. channel width diagram a comparison between the PMOS devices of figures 1 and 2. In particular, it shows the surface enrichment influence on the concentration profile along the channel;
- Figure 4 compares the planar structure with the trench structure in an intermediate working step, both realised according to the prior art. It underlines, for both structures, the typical magnitudes on which the surface covered by the gate oxide depends;
- Figure 5 is a vertical-section and enlarged-scale schematic view of a vertical MOS electronic device according to the present invention underlining the specific features introduced by the present invention (oxide thickening and corresponding enrichment of the epitaxial layer between body wells);
- Figures 6 are respective vertical-section and enlarged-scale schematic views of the PMOS device according to a first method of the invention undergoing different steps of the manufacturing method;
- Figures 7 are respective vertical-section and enlarged-scale schematic views of the PMOS device according to a second method of the invention undergoing different steps of the manufacturing method;
- Figure 8 shows on a diagram the vertical section of a transistor at an intermediate working step according to the invention and obtained by means of simulations of the method according to the invention.

### Detailed description

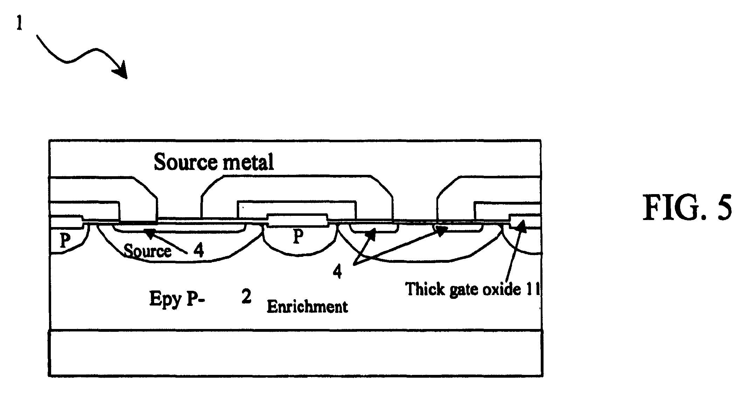

With reference to the figures, and particularly to the examples of figures 5 and the followings, a MOS transistor electronic device, particularly of the PMOS type, according to the method of the present invention is globally and schematically indicated.

The process steps and the structures described hereafter do not form a complete process flow for manufacturing integrated circuits. In fact, the present invention can be implemented together with the integrated circuit manufacturing techniques presently used in this field and only those commonly used process steps which are necessary to understand the invention are described hereafter.

The figures representing cross sections of portions of an integrated circuit during the manufacturing are not drawn to scale, but they are drawn instead in order to show the important features of the invention.

The transistor device 1 is obtained from a semiconductor substrate 2 covered by an oxide protective layer.

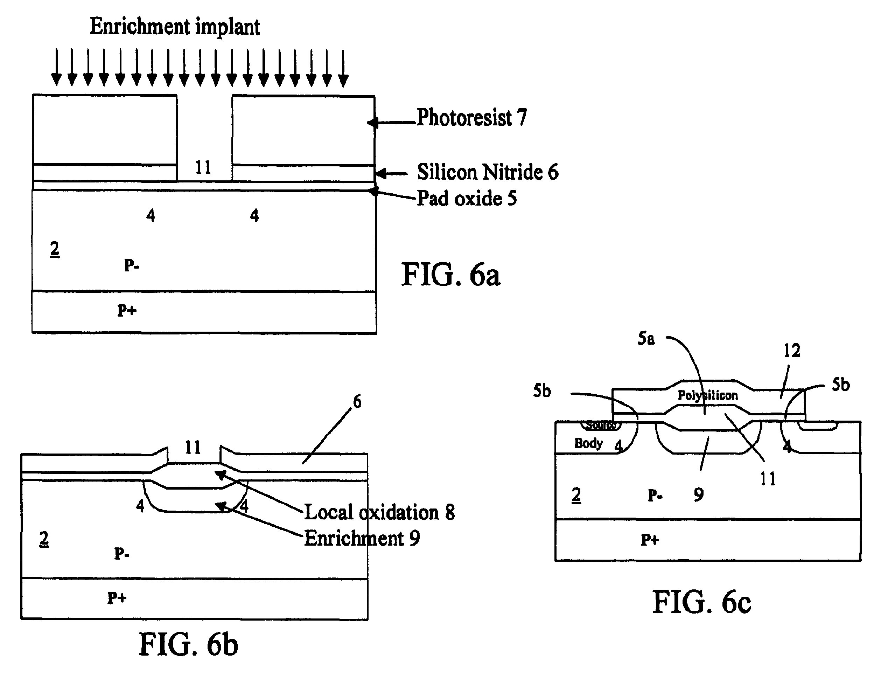

According to a preferred embodiment, described with reference to figures 6a to 6c, the method of the present invention is characterised in that it comprises the following operative steps:
i- defining, in a conventional way, the active areas 4 of the transistor 1 and of a channel region between them, by opening the oxide protective layer on the substrate 2;
ii- growing a pad oxide 5 on the active areas 4 and on the channel for a thickness of about 100-500 A; a gate region according to the method of the invention will be realised on the channel;
iii- depositing a nitride layer 6 on the oxide layer 5. The thickness of this nitride layer 6 can reach 300-900 A;
iv- a photomasking step is now provided to define the inactive areas 11 which must have a thicker oxide layer. This step is implemented by means of a photoresist layer 7.
v- an etching step of the nitride layer 6 is then performed removing the same on the channel up to expose the oxide layer 5, as shown in figure 6a;
vi- a further implant step allows an enrichment of a central area of channel 9, underlying the area 11, to be realised with P or As ions for a N-channel transistor and B or Al ions for a P-channel transistor, the implant energy can be regulated between 60-500 KeV while ion doses can range from 1E12 and 1E13 ions /cm².
vii- the removal of the resist layer 7 is then performed;
viii- the following step provides the growth of a first gate oxide layer 8 of variable thickness between 800 and 3000 A. This step can provide a possible dopant "drive in", as shown in figure 6b;
ix- a wet etching of the nitride layer 6 by means of the H₃PO₄ acid or other convenient method is also provided;
x- a selective wet etching with HF acid allows the oxide layer 5 on the active areas 4 to be also removed. The etching time must be such as to remove the whole pad oxide layer 5 but without removing the first gate oxide layer 8. The greater is the difference between the two oxide thicknesses, the widest are the margins of etching times;
xi- a growth of a sacrificial oxide layer of about 100-600 A is then performed;
xii- this sacrificial oxide layer is immediately wet-etched by means of HF acid to expose the gate region of the transistor 1 on the channel but at the periphery of the area 11. In this case too, the etching time must be such as to remove the whole sacrificial oxide but without removing the first gate oxide layer 8. The greater is the difference between the two oxide thicknesses, the widest are the margins of etching times;
xiii- the method continues with the growth of a second gate oxide layer, having a variable thickness ranging from 100 to 1000 A;
xvi- a conductive layer 12, for example of polycristalline silicon, called poly, is deposited on the gate region, which is doped to change conductivity at will;
xv- the so-obtained MOS transistor structure can be completed with further process steps continuing according to the prior art and leading to define traditional body and source wells housing the transistor active areas 4, as shown in figure 6c. Thanks to the present invention, these body wells can be realised with reduced mutual distance.

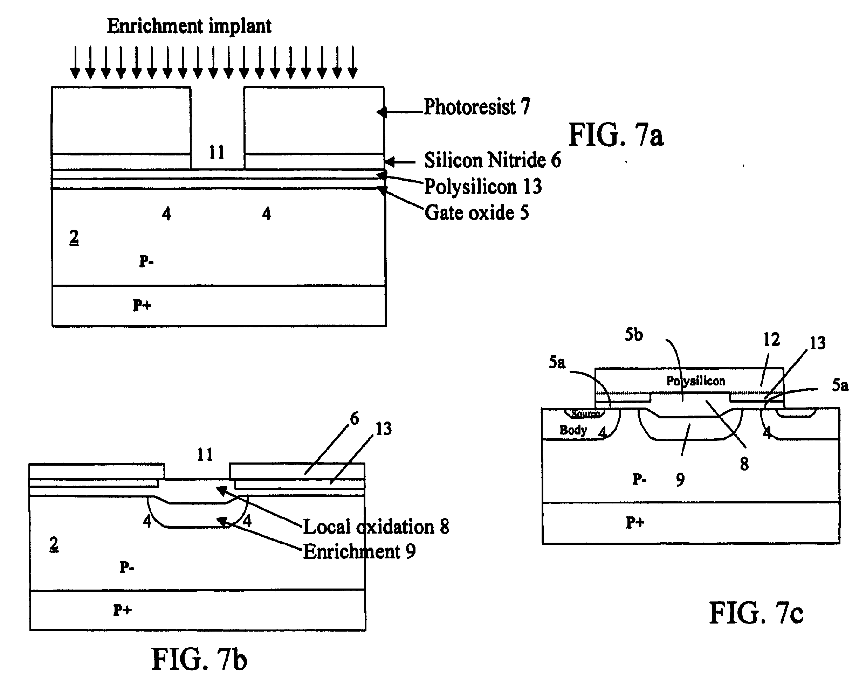

In accordance with a second preferred embodiment, described with reference to figures 7a to 7c, the method of the present invention is characterised in that it comprises the following operative steps:
i- defining, in a conventional way, the active areas 4 of the transistor 1 and of a channel region between them, by opening the oxide protective layer on the substrate 2;
ii- growing the oxide layer 5 on the active areas 4 and on the channel for the thickness required for the device correct operation (100-1500 A);
iii- depositing a polysilicon layer 13 having a thickness being lower or equal to half the thickness of a part of the thicker oxide layer 5a;
iv- depositing a nitride layer 6 of 300-900 A on the polysilicon layer 13;
v- photomasking to define the inactive areas 11 which must have a thicker oxide layer;
vi- etching the nitride layer 6 removing the same on the channel, as shown in figure 7a, up to expose the polysilicon layer 13;
vii- further implanting to realise the enrichment region 9 in the channel central area underlying the area 11, using the photoresist as implant window. The implant can be performed with P or As ions for a N-channel transistor and B or Al ions for a P-channel transistor, the implant energy can be regulated between 60-500 KeV while ion doses can range from 1E12 and 1E13 ions/cm².
viii- removing the photoresist and completely oxidising the polysilicon not covered by the nitride layer 6, as shown in figure 7b;
ix- etching the nitride layer 6 with the prior art techniques;
x- depositing a conductive layer 12 to realise the gate electrode, for example of polycristalline silicon, called poly, which is doped to change conductivity at will;
xi- the so-obtained MOS transistor structure can be completed with further process steps continuing according to the prior art and leading to define traditional body and source wells housing the transistor active areas 4, as shown in figure 7c. Thanks to the present invention, these body wells can be realised with reduced mutual distance.

Advantageously, it is also possible to use a metal layer (for example of Ti, W or Co) as conductive layer 12 to realise the gate electrode.

The previous detailed descriptions show in an evident way how the transistor obtained with the method according to the invention is a planar MOS with a double thickness of gate oxide, i.e. with a thinner oxide layer in the channel area and a thicker oxide layer in the central channel inactive area.

In particular, the final MOS device comprises a gate oxide layer having thin oxide side portions 5a and a thick oxide central portion 5b, this thick oxide central portion 5b being in correspondence with the channel central inactive area.

Moreover, according to the alternative embodiment of the method according to the invention, the final MOS device comprises a polysilicon layer 13 on the side portions 5a of the gate oxide layer.

Moreover, the enrichment region 9 in the JFET area underlying and self-aligned with the thicker oxide central portion 5a allows the distance between two adjacent body wells and thus the gate oxide surface to be reduced, obtaining an increased integration or packing density of the so-obtained transistors.

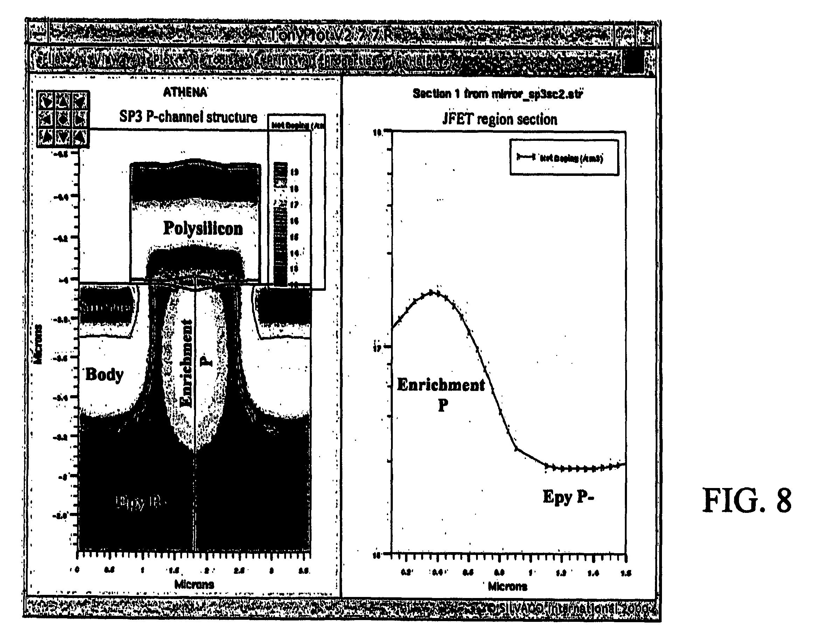

Figures 8 shows the vertical section of a transistor realised according to the invention. This section has been obtained by means of process simulations wherein it is possible to see the gate oxide thickening and the enrichment layer position. Figure 8 also shows the concentration profile along the central line between two body wells.

## Claims

1. A vertical-conduction and planar-structure MOS device having a double thickness of gate oxide **characterised in that** it comprises:
- a first portion (5a) of gate oxide having a lower thickness in a channel area close to the active areas (4), and a second portion (5b) of thicker gate oxide in a central area (11) on a JFET area and
- an enrichment region (9) in said JFET area under said second portion (5b) of thicker gate oxide (11).

2. A MOS device according to claim 1, **characterised in that** said enrichment region (9) is self-aligned with said second portion (5b) of thicker gate oxide.

3. A MOS device according to claim 1, **characterised in that** said double thickness of gate oxide globally has a reduced surface reducing the distance between adjacent body wells enveloping said active areas (4).

4. A MOS device according to claim 1, **characterised in that** it comprises a polysilicon layer (13) on said first portion (5a) of thin gate oxide.

5. A MOS device according any of the previous claims, **characterised in that** it comprises respective first portions (5a) of thin gate oxide at the periphery of said second portion (5b) of thicker gate oxide.

6. A method for realising on a semiconductor substrate (2) MOS transistor (1) electronic devices with improved static and dynamic performances and high scaling down density, said transistors having traditional active areas (4) defined in the substrate (2) at the periphery of a channel region whereon a gate region is realised, **characterised in that** it comprises at least the steps of:
- realising the MOS transistor starting from a planar structure with a double thickness of gate oxide comprising a thin layer in the channel area close to the active areas (4) and a thicker layer in the central area (11) on the channel; and
- realising an enrichment region (9) in the JFET area below said thicker layer.

7. A method according to claim 6, **characterised in that** said enrichment region (9) is realised in parallel and in a self-aligned way with said thicker oxide layer.

8. A method according to claim 6, **characterised in that** said double thickness of gate oxide globally has a reduced surface reducing the distance between adjacent body wells enveloping said active areas (4).

9. A method according to claim 6, **characterised in that**, after defining the active areas (4) at the periphery of the channel region, it comprises the following operating steps:
- growing a pad oxide (5) on the active areas (4) and on the channel for a thickness of about 100-500 A;
- depositing a nitride layer (6) of 300-900 A on the oxide layer (5);
- photomasking to define the inactive areas (11) which must have a thicker oxide layer;
- etching the nitride layer (6) removing the same on the channel up to expose the oxide layer (5);
- further implanting to realise said enrichment region (9) in the channel central area using the photoresist as implant window;
- removing the photoresist and growing said first thicker gate oxide layer (8);
- etching the nitride layer (6);
- selectively etching to remove also the oxide layer (5) on the active areas (4);
- growing a sacrificial oxide layer;
- wet etching this sacrificial oxide layer to expose the gate region of the transistor (1) on the channel;
- growing a second gate oxide layer at the periphery of the thicker oxide area (11).

10. A method according to claim 9, **characterised in that** said implant step is performed with P, As or Sb ions for a N-channel transistor and B or Al ions for a P-channel transistor, the implant energy is regulated between 60-900 KeV while ion doses can range from 1E12 and 1E13 ions/cm².

11. A method according to claim 6, **characterised in that**, after defining the active areas (4) at the periphery of the channel region, comprises the following operating steps:
- growing the gate oxide on the active areas (4) and on the channel for the thickness required for the device correct operation (100-1500 A);
- depositing a polysilicon layer (13) having a thickness being lower or equal to half the thickness of the thicker gate oxide part;
- depositing a nitride layer (6) of 300-900 A on the polysilicon layer (13);
- photomasking to define the inactive areas (11) which must have a thicker oxide layer;
- etching the nitride layer (6) removing the same on the channel up to expose the polysilicon layer (13);
- further implanting to realise said enrichment region (9) in the channel central area using the photoresist as implant window;
- removing the photoresist and completely oxidising the polysilicon (13) not covered by the nitride layer (6);
- etching the nitride layer (6);
- depositing a conductive layer (12) to realise the gate electrode.

12. A method according to claim 11, **characterised in that** said implant step is performed with P, As or Sb ions for a N-channel transistor and B or Al ions for a P-channel transistor, the implant energy is regulated between 60-900 KeV while ion doses can range from 1E12 and 1E13 ions/cm².

13. A method according to claim 11, **characterised in that** said conductive layer (12) to realise the gate electrode is composed of conveniently doped polysilicon.

14. A method according to claim 11, **characterised in that** said conductive layer (12) to realise the gate electrode is composed of a metal layer.
